# EUROPÄISCHE PATENTSCHRIFT

(11) **EP 1 031 881 B1**
(45) Veröffentlichungstag und Bekanntmachung des Hinweises auf die Patenterteilung: **05.02.2003**
(21) Anmeldenummer: 00103353.9
(22) Anmeldetag: 22.02.2000
(51) Int. Cl.: G03F 7/09, G03G 5/10, B41C 1/10

(54) **Pigmentiertes und rückseitenbeschichtetes Aufzeichnungsmaterial zur Herstellung von Offsetdruckplatten**
Pigmented and back side coated recording material for producing offset printing plates
Matériau d'enregistrement pigmenté et revêtu sur la face arrière pour la fabrication de plaques d'impression offset

(30) Priorität: 26.02.1999 DE 19908529
(43) Veröffentlichungstag der Anmeldung: 30.08.2000
(73) Patentinhaber: AGFA-GEVAERT, 2640 Mortsel (BE)
(72) Erfinder: Denzinger, Steffen, Dr. Dipl.-Chem., 55128 Mainz (DE); Dörr, Michael, Dr. Dipl.-Chem., 55128 Mainz (DE); Elsässer, Andreas, Dr. Dipl.-Chem., 65510 Idstein (DE); Hultzsch, Günther, Dr. Dipl.-Chem., 65187 Wiesbaden (DE); Gates, Allen P., Dr., Knaresborough, North Yorkshire (GB); Robinson, Roland, Leeds LS15 8PA (GB)

(56) Entgegenhaltungen:
- EP-A- 0 490 515
- EP-A- 0 528 395
- DATABASE WPI Section Ch, Week 199750 Derwent Publications Ltd., London, GB; Class A14, AN 1997-546961 XP002140756 & JP 09 265176 A (FUJI PHOTO FILM CO LTD), 7. Oktober 1997 (1997-10-07)

## Beschreibung

Die vorliegende Erfindung betrifft ein Aufzeichnungsmaterial zur Herstellung von Offsetdruckplatten, umfassend einen Metallträger, auf dessen Vorderseite sich eine lichtempfindliche Schicht und auf dessen Rückseite sich eine Schicht aus einem organischen polymeren Material mit einer Glas-Übergangstemperatur T_{g} von 45 °C oder mehr befindet.

Aufzeichnungsmaterialien zur Herstellung von Offsetdruckplatten werden üblicherweise in Stapeln zu 20 Stück oder mehr ausgeliefert. Nach längerer Lagerzeit, bei erhöhtem Druck und/oder erhöhter Temperatur kleben die einzelnen Platten häufig aneinander, und es können sich während des Transports oder bei der Entnahme der Platten aus dem Stapel Kratzer in der lichtempfindlichen Schicht oder auf der Rückseite des Trägers bilden. Um das zu verhindern, werden üblicherweise Papierbogen zwischen die Platten gelegt. Bei In-line-Konfektionierungsanlagen wird das Zwischenlagepapier in der Regel automatisch eingelegt. Dieser Schritt ist relativ langsam und auch fehleranfällig.

Solche Zwischenlagen sind insbesondere bei Aufzeichnungsmateriallen mit einem Aluminiumträger ohne Rückseitenbeschichtung notwendig. Das Papier kann jedoch auf die lichtempfindliche Schicht einwirken und diese verändern. Bestandteile des Papiers können eine Änderung des pH-Werts, der Lichtempfindlichkeit und/oder eine schnellere Alterung der lichtempfindlichen Schicht bewirken, was absolut unerwünscht ist. Mit oberflächenversiegelten Papieren läßt sich das Problem verringern. Solche Papiere sind jedoch deutlich teurer.

In der Druckerei werden die Plattenstapel wiederum in automatischen Anlagen verarbeitet. Das Zwischenlagepapier wird dabei in der Regel durch Ausblasen entfernt. Auch das geschieht relativ langsam und ist störanfällig. Das Zwischenlagepapier kann zudem nicht wiederverwendet werden und muß als Abfall entsorgt werden. Gemäß der JP-A 02-040 657 tritt das Problem nicht mehr auf bei einem Aufzeichnungsmaterial mit einem Aluminiumträger, der auf der einen Seite eine lichtempfindliche Schicht und auf der anderen Seite eine UV-gehärtete Schicht aus einem photopolymerisierbaren Material enthält. Die auf der Rückseite aufgebrachte Schicht kann neben den Monomeren noch Photosensibilisatoren, thermischen Polymerisationsinhibitoren, Bindemittel, Füllstoffe und andere Additive enthalten. Sie wirkt als Mattierungsschicht.

In der JP-A 06-202 312 ist Aufzeichnungsmaterial für die Herstellung von Offsetdruckplatten offenbart, dessen Aluminiumträger ebenfalls auf der Rückseite mit einem organischen Polymer, wie Polyethylen, Polypropylen, Polybutadien, Polyester, Polycarbonat, Polyvinylacetal, Polyvinylchlorid, Polystyrol oder einem Methacrylat-Harz, beschichtet ist. Durch die Rückseitenbeschichtung wird der Angriff des wäßrig-alkalischen Entwicklers auf den Aluminiumträger vermindert. Die lichtempfindliche Schicht in diesem Aufzeichnungsmaterial enthält 1 bis 10 Gew.-% einer im Entwickler unlöslichen Verbindung.

Ein Aufzeichnungsmaterial mit einem anodisierten Aluminiumträger, einer photopolymerisierbaren Schicht auf der durch das Anodisieren erzeugten Aluminiumoxidschicht sowie einer 0,1 bis 8,0 µm dicken Rückseitenbeschichtung ist in der JP-A 09-265 176 offenbart. Diese Beschichtung besteht aus einem gesättigten copolymerisierten Polyesterharz, einem Phenoxyharz, einem Polyvinylacetal oder einem Vinylidenchlorid-Copolymer, das jeweils eine Glas-Übergangstemperatur T_{g} von 20 °C oder mehr aufweist. Ein Verkratzen der Platten während des Transports im Stapel wie auch ein Ablösen der strahlungsempfindlichen Schicht durch ein zu festes Anhaften an der Rückseite der darüber liegenden Platte sollen damit verhindert werden.

Ein Aufzeichnungsmaterial zur Herstellung von Offsetdruckplatten, das ohne Zwischenlagepapier gestapelt werden kann, ist auch in der EP-A 528 395 beschrieben. Es umfaßt einen (Aluminium-)Träger, eine 0,01 bis 8,0 um dicke Schicht aus einem organischen polymeren Material mit einer Glas-Übergangstemperatur von nicht weniger als 20 °C auf der Rückseite des Trägers und eine lichtempfindliche Schicht auf der Vorderseite des Trägers. Auf der lichtempfindlichen Schicht wiederum befindet sich eine diskontinuierliche Mattierungsschicht, die aus Partikeln mit einem mittleren Durchmesser von nicht mehr als 100 µm und einer durchschnittlichen Höhe von nicht mehr als 10 µm besteht. Das Gewicht der Mattierungsschicht beträgt 5 bis 200 mg pro Quadratmeter. Die Mattierungsschicht bewirkt, daß sich die Luft zwischen Vorlage und lichtempfindlicher Schicht im Vakuum-Kontaktkopierrahmen schneller abpumpen läßt. Herstellen läßt sich die Mattierungsschicht beispielsweise durch Aufsprühen einer Lösung eines Methylmethacrylat/Ethylacrylat/Acrylsäure-Terpolymers, dessen Carboxygruppen teilweise in Salzform vorliegen, in einem elektrostatischen Feld mit Hilfe einer Sprühglocke, die mit etwa 25.000 Umdrehungen pro Minute rotiert. Allgemein ist die Mattierungsschicht in Wasser oder wäßrigem Alkali löslich. Mattierungsschichten, insbesondere solche aus einem Material mit einer niedrigen Glas-Übergangstemperatur, neigen jedoch dazu, mit der Rückseite der im Stapel darüberliegenden Platte zu verkleben. Größere Bereiche der strahlungsempfindlichen Schicht können dadurch abgelöst werden, so daß das Aufzeichnungsmaterial dann nicht mehr weiter verwendet werden kann.

Gegenstand der EP-A 490 515 ist eine vorsensibilisierte Druckplatte, die nach dem bildmäßigen Belichten mit einer wäßrigen Alkalimetallsilikat-Lösung entwickelt wird. Um zu verhindern, daß der Entwickler Aluminium aus der Rückseite der Platte herauslöst, ist diese mit einer organischen polymeren Beschichtung versehen, die im Entwickler unlöslich ist. Die Beschichtung enthält Polymere, wie Polyethylen, Polypropylen, Polybuten, Polybutadien, Polyamid, Polyurethan, Polyharnstoff, Polyimid, Polysiloxan, Polycarbonat, Epoxharze, Polyvinylchlorid, Polyvinylidenchlorid oder Polystyrol. Sie kann auch eine thermisch oder photochemisch härtende Komponente umfassen.

Es bestand daher nach wie vor die Aufgabe, ein strahlungsempfindliches Aufzeichnungsmaterial zur Herstellung von Flachdruckplatten zur Verfügung zu stellen, das ohne Zwischenlagepapier gestapelt werden kann. Auch nach längerer Lagerung undloder nach Einwirkung erhöhter Temperaturen sowie nach längerem Transport sollen sich die Platten unbeschädigt dem Stapel entnehmen lassen. Zudem sollen die Platten kurze Evakuierzeiten im Vakuum-Kontaktkopierrahmen zulassen. Beim Entwickeln soll der wäßrig-alkalische Entwickler zudem nur wenig mit Aluminiumhydroxid belastet werden.

Diese Aufgabe läßt sich lösen, wenn die Vorderseite der Platte nicht mattiert, sondern pigmentiert ist. Die Abstandshalter sind in die strahlungsempfindliche Schicht oder eine darüber liegende Deckschicht eingebettet.

Gegenstand der vorliegenden Anmeldung ist demgemäß ein Aufzeichnungsmaterial zur Herstellung einer Offsetdruckplatte mit einem Träger, auf dessen Vorderseite sich eine lichtempfindliche Bildschicht und auf dessen Rückseite sich eine Schicht aus einem organischen polymeren Material mit einer Glas-Übergangstemperatur T_{g} von 45 °C oder mehr befindet, das dadurch gekennzeichnet ist, daß die lichtempfindliche Schicht oder eine gegebenenfalls darüber befindliche Deckschicht pigmentiert ist.

Das Material, mit dem die Pigmentierung erreicht wird, ist allgemein anorganischer Art und praktisch unlöslich in Wasser. Die mittlere Komgröße der Pigmentierungspartikel beträgt allgemein 0,1 bis 20,0 µm, bevorzugt 1,0 bis 15,0 µm, besonders bevorzugt 3 bis 5 µm. Der Anteil der Pigmentierungsmittel wird so gewählt, daß die Oberfläche des Aufzeichnungsmaterials eine Glätte nach Bekk von < 1000 Sekunden, vorzugsweise 20 bis 250 Sekunden (bestimmt nach DIN 53 107, Verfahren A) aufweist.

Bevorzugte Pigmentierungsmittel sind Kieselsäureprodukte mit einer mittleren Korngröße von 3 bis 5 µm und einer Ausschlußgrenze von 15 µm. In einer bevorzugten Ausführungsform sind die Kieselsäureprodukte kombiniert mit einem Tensid, insbesondere einem Tensid mit Siloxan-Einheiten. Der Anteil des Tensids liegt allgemein bei 0,01 bis 2 Gew.-%, bezogen auf das Trockengewicht der strahlungsempfindlichen Schicht. Bevorzugt sind ferner Kieselsäureprodukte, die hydrophobiert (insbesondere mit Wachs) oder chemisch modifiziert (insbesondere mit Silanen) sind .

Als Kieselsäureprodukte werden hier synthetische Kieselsäuren und Silikate nach DIN 55 921 bezeichnet. Dementsprechend können sowohl reines SiO₂ wie auch metalloxidhaltige Kieselsäuren (z.B. Aluminiumsilikate) zur Anwendung kommen, auch wenn eine genaue Unterscheidung zwischen beiden nicht möglich ist. Daher nähert sich der Begriff "Kieselsäureprodukt" dem gebräuchlichen Ausdruck "silica", der nicht oder nicht immer zwischen Kieselsäuren und Silicaten unterscheidet. Als Kieselsäureprodukte können beispielsweise ®Syloid-Typen der Fa. Grace, ®Silcron von Lanco, ®Gasil von Crosfield, OK/HK-Typen der Degussa und ®Satintone der Engelhard-Chemie eingesetzt werden.

Unter "mittlere Korngröße" ist der 50 %-Wert der kumulativen Massen- oder Volumenverteilungskurve zu verstehen, wie er in der entsprechenden DIN-Vorschrift 66 141 festgelegt ist. Die Ausschlußgrenze bezeichnet den 100 %-Wert. In dieser Vorschrift sind die Grundlagen zur Darstellung von Kom-(Teilchen)-größenverteilungen dargestellt. Sie gelten für alle kömigen Stoffe, unabhängig von der Art des gemessenen Feinheitsmerkmals. Zur Bestimmung der Kennwerte liegen verschiedene Verfahren vor, wie Sedimentationsmessungen, bildanalytische Auswertung von elektronenmikroskopischen Aufnahmen, Leitfähigkeitsmessungen, Lichtstreuung.

Die Menge an Kieselsäureprodukt, die zur Erzielung einer Glätte nach Bekk von < 1000 Sekunden, bevorzugt 20 bis 250 Sekunden, erforderlich ist, variiert stark. Abhängig ist sie von der mittleren Korngröße der Mattierungspartikel, daneben auch vom Schichtgewicht der strahlungsempfindlichen Schicht bzw. der Deckschicht sowie von der Rauhigkeit der Trägeroberfläche. Es war jedoch in jedem Fall überraschend, daß sich mit den relativ harten anorganischen Mattierungsmitteln der gewünschte Effekt erreichen ließ und auch nach längerer Lagerung oder nach einem Transport der Platten im Stapel auch unter Druck keine Kratzer beobachtet wurden.

Wie bereits beschrieben, können die Kieselsäurefüllstoffe in der lichtempfindlichen Schicht oder in einer darüber befindlichen Deckschicht enthalten sein. Es ist auch möglich, daß sich auf einer pigmentierten strahlungsempfindlichen Schicht eine nicht pigmentierte, transparente Deckschicht befindet. Diese darf jedoch nicht zu dick sein, d.h. die mittlere Korngröße der Mattierungspartikel muß größer sein als die Gesamtdicke von lichtempfindlicher Schicht und Deckschicht zusammen.

Beschreibung der Zeichnungen:

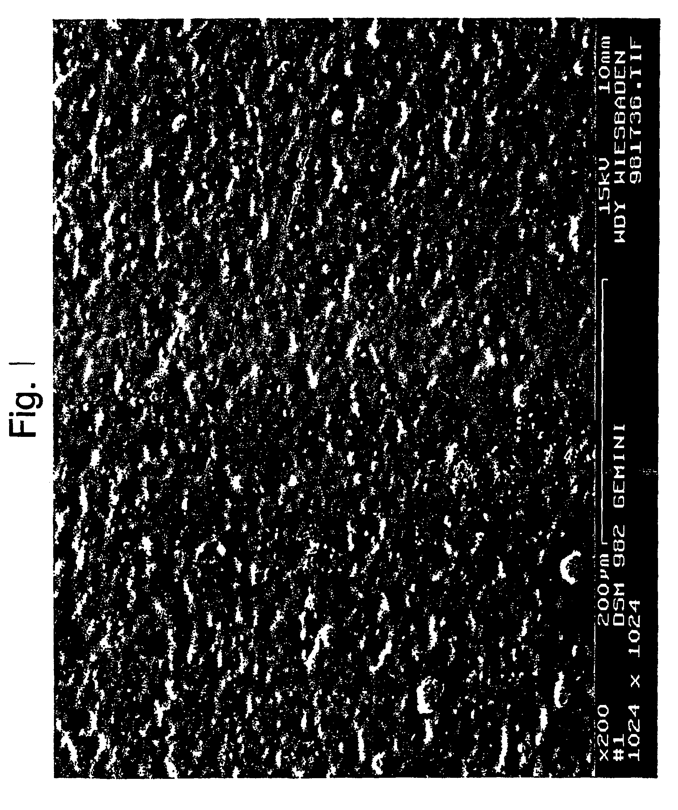

- Fig. 1:: Rasterelektronenmikroskopische Aufnahme der Vorderseite des erfindungsgemäßen Aufzeichnungsmaterials aus Beispiel 16 nach der Lagerung.

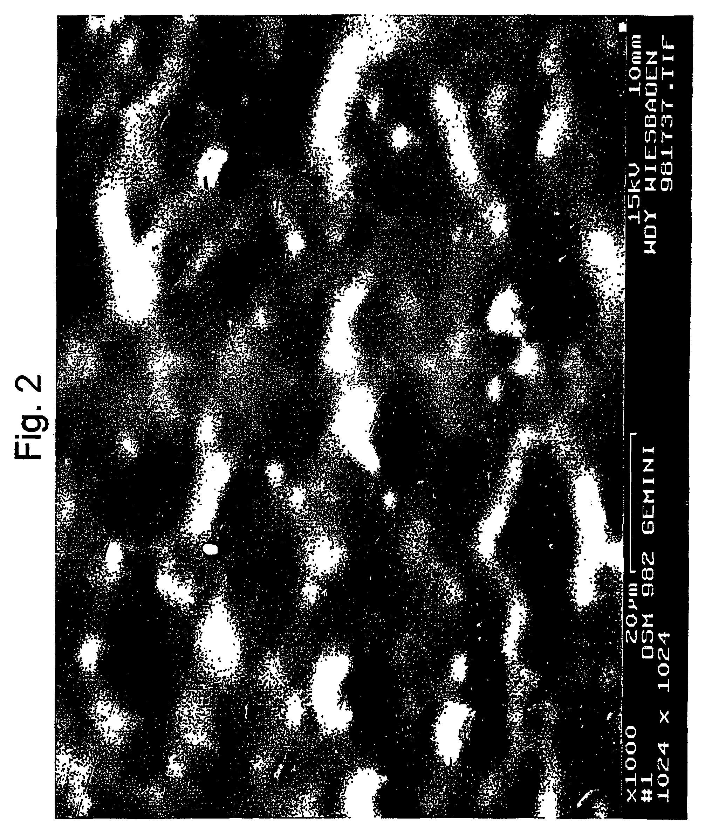

- Fig. 2:: Oberfläche wie vorher, jedoch stärker vergrößert.

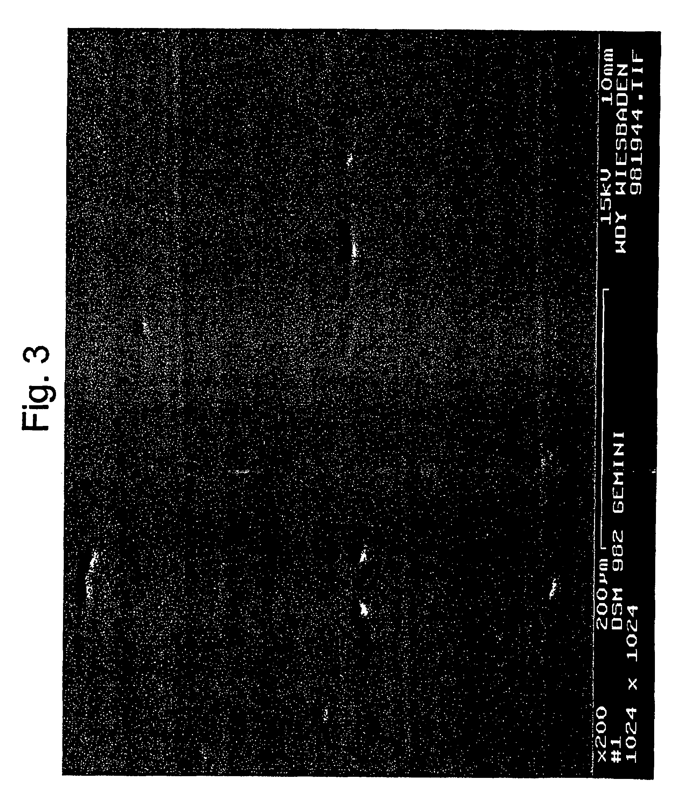

- Fig. 3:: Rückseite des Aufzeichnungsmaterials aus Beispiel 16 nach der Lagerung. Es sind keine Anhaftungen oder Verklebungen sichtbar.

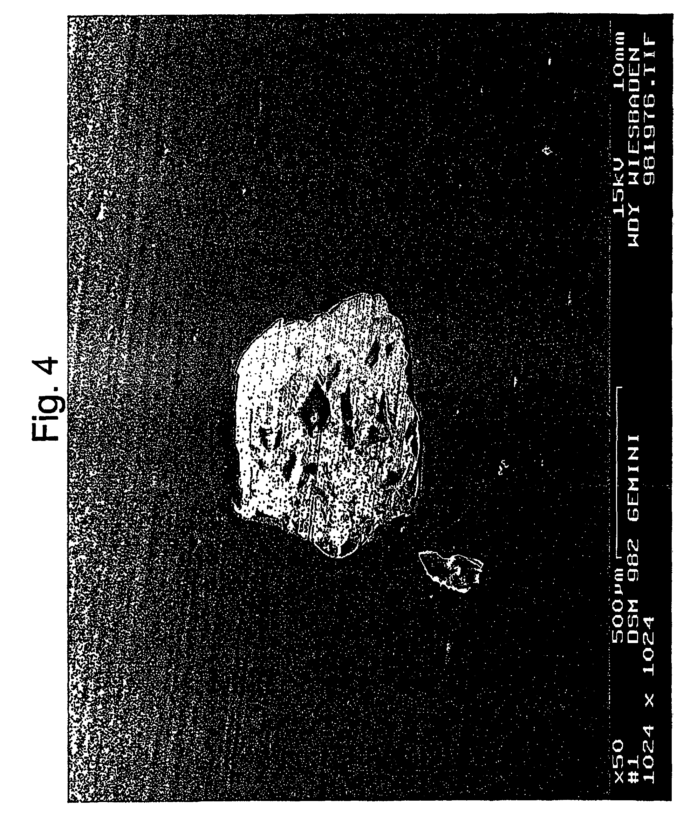

- Fig. 4:: Rückseite des Aufzeichnungsmaterials aus dem Vergleichsbeispiel 17 nach der Lagerung. Anhaftungen sind deutlich erkennbar.

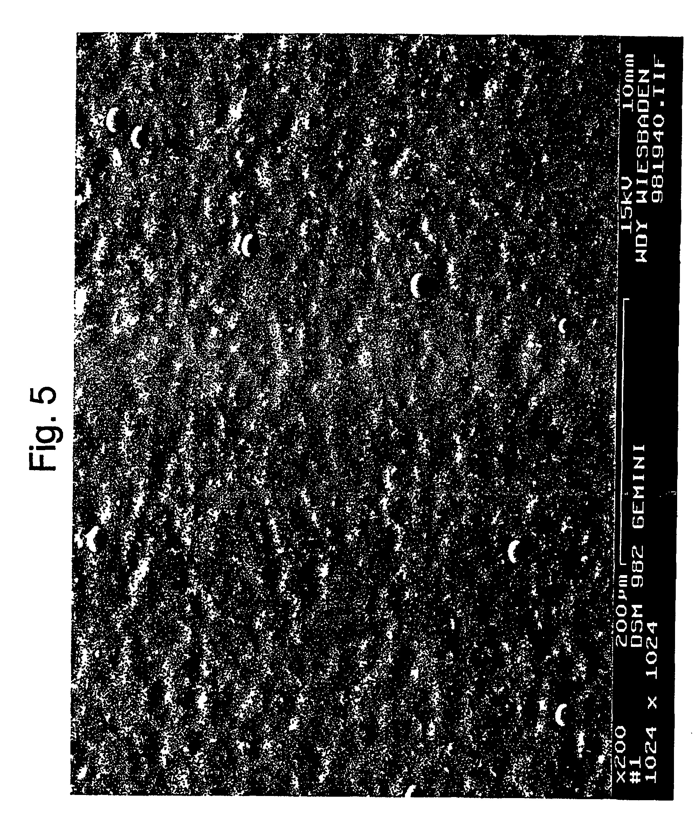

- Fig. 5:: Vorderseite des Aufzeichnungsmaterials aus Vergleichsbeispiel 22 vor der Lagerung.

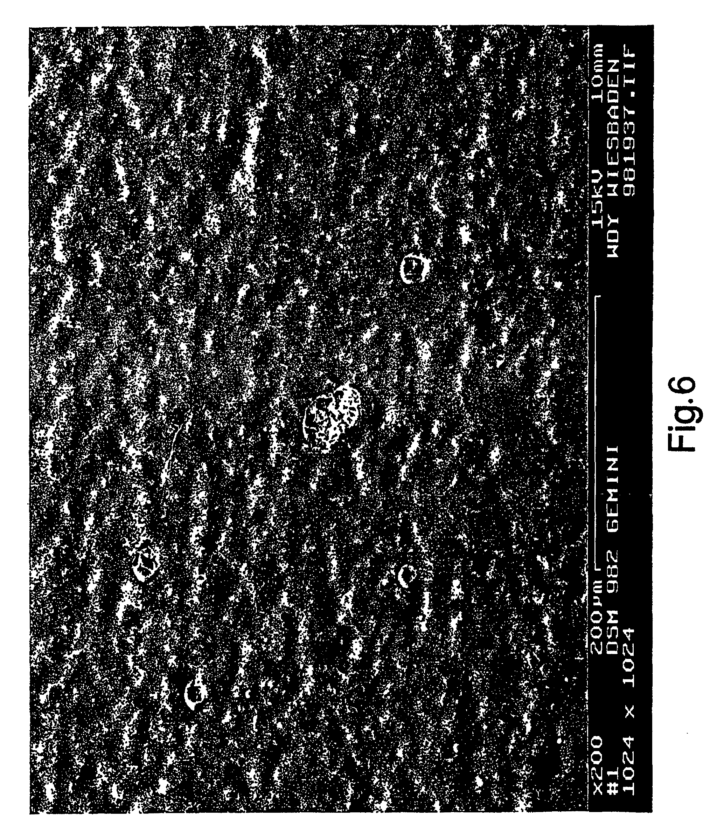

- Fig. 6:: Oberfläche wie vorher nach der Lagerung.

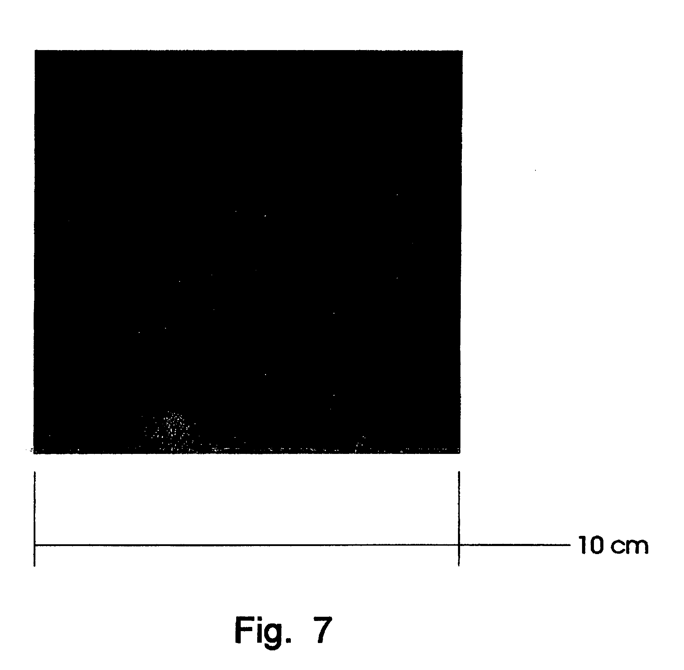

- Fig. 7:: Ergebnis, das mit einer Druckplatte erzielt wurde, die aus dem gelagerten Aufzeichnungsmaterials gemäß Vergleichsbeispiel 22 hergestellt wurde.

Die Bestimmung der Glätte nach Bekk erfolgt nach DIN 53 107, Verfahren A, wobei man die Zeit mißt, innerhalb derer durch das durchgesaugten Luftvolumen der Druck in dem Vakuumbehälter für die Meßprobe von -507 mbar auf -489 mbar ansteigt.

Das Pigmentierungsmittel ist vorzugsweise in einem Anteil von 0,01 bis 10 Gew.-%, insbesondere 0,1 bis 5 Gew.-%, bezogen auf das Trockengewicht der Schicht, vorhanden. Die zur Pigmentierung verwendeten Kieselsäureprodukte können, um eine leichtere Dispergierbarkeit zu erzielen, durch Beschichtung, z.B. mit Wachs, oder durch Reaktion z.B. mit Silanen modifiziert sein.

Die verwendeten Tenside sind bevorzugt Dialkylsiloxane, die zusätzlich durch Alkylenoxideinheiten oder Säureeinheiten modifiziert sein können. Der für eine einwandfreie Beschichtung ohne Hofbildung erforderliche Anteil hängt von der Füllstoffmenge ab. In der Regel sind 0,01 bis 2, insbesondere 0,05 bis 1 Gew.-%, bezogen auf das Trockengewicht der Schicht, ausreichend.

Als Beispiele für verwendete Tenside werden Produkte wie ®Tegoglide, ®Tegopren (Goldschmidt AG), ®Edaplan (Münzing), ®Byk (Byk-Chemie), ®Baysilon (Bayer AG) oder auch verschiedene Siliconöle der Wacker-Chemie GmbH genannt.

Die strahlungsempfindliche Schicht selbst kann positiv oder negativ arbeitend sein. Sie weist üblicherweise ein Schichtgewicht von 0,1 bis 6 g/m², bevorzugt von 0,5 bis 4,0 g/m², auf.

Als strahlungsempfindliche Verbindung für positiv arbeitende Gemische (insbesondere solche, die für eine Belichtung im Wellenlängenbereich von 350 bis 450 nm bestimmt sind) kann eine Chinondiazid-Verbindung, insbesondere eine Naphthochinondiazid-Verbindung, gewählt werden. Weiterhin eignen sich dafür Kombinationen von Verbindungen, die bei Bestrahlung eine starke Säure bilden, und Verbindungen, die mindestens eine durch eine Säure spaltbare C-O-C-Bindung enthalten. Gemische, die mit IR-Strahlung im Bereich von 750 bis 1100 nm belichtbar sein sollen, enthalten als thermischen Sensibilisator beispielsweise Ruß bei Breitbandsensibilisierung oder Methinfarbstoffe als spektrale Sensibilisatoren.

Für negativ arbeitende Gemische kann als strahlungsempfindliche Komponente eine Verbindung mit Diazoniumsalzgruppen oder ein radikalisch polymerisierbares System, bestehend aus Photoinitiator(en) und ethylenisch ungesättigten Verbindungen, die radikalisch polymerisierbar sind, oder eine Kombination dieser Komponenten, eingesetzt werden.

Als strahlungsempfindliche Komponenten eignen sich auch positiv-arbeitende Photoleiter oder ein Gemisch von Photoleitern und Sensibilisatoren.

Die 1,2-Chinondiazide sind bevorzugt 1,2-Naphthochinon-2-diazid-4- oder -5-sulfonsäureester oder -amide. Davon wiederum sind die Ester aus 1,2-Naphtochinon-2-diazid-4- oder -5-sulfonsäure und 2,5-Dihydroxy-benzophenon, 2,3,4-Trihydroxy-benzophenon, 2,3,4-Trihydroxy-4'-methyl-benzophenon, 2,3,4-Trihydroxy-4'-methoxy-benzophenon, 2,3,4,4'-Tetrahydroxy-benzophenon, 2,3,4,2',4'-Pentahydroxy-benzophenon, 5,5'-Dialkanoyl-2,3,4,2',3',4'-hexahydroxy-diphenylmethan-(speziell 5,5'-Diacetyl-2,3,4,2',3',4'-hexahydroxy-diphenylmethan) oder 5,5'-Dibenzoyl-2,3,4,2',3',4'-hexahydroxy-diphenylmethan bevorzugt. Die Polyhydroxyverbindungen sind dabei in der Regel partiell verestert. Der Anteil der 1,2-Chinondiazidverbindung(en) beträgt allgemein 3 bis 50 Gew.-%, bevorzugt 7 bis 35 Gew.-%, bezogen auf das Gesamtgewicht der nichtflüchtigen Bestandteile der strahlungsempfindlichen Schicht.

Es ist auch möglich, die 1,2-Chinondiazidverbindungen in Form ihrer Ester oder Amide mit den erfindungsgemäßen Polymeren einzusetzen, wenn diese umsetzbare Hydroxy- oder Aminogruppen enthalten. Die Veresterung/Amidierung der entsprechenden 1,2-Chinondiazidsulfon- oder -carbonsäuren mit den Hydroxy- und/oder Aminogruppen der zugrunde liegenden Polymere erfolgt dabei nach Verfahren, die dem Fachmann bekannt sind.

Besonders geeignete säurespaltbare Verbindungen sind
A) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
B) Oligomer- und Polymerverbindungen mit wiederkehrenden Acetal- und/oder Ketalgruppierungen in der Hauptkette und
C) Verbindungen mit mindestens einer Enolether- oder N-Acyliminocarbonatgruppierung.

Durch Säure spaltbare Verbindungen des Typs A) als Komponenten strahlungsempfindlicher Gemische sind in der EP-A 0 022 571 ausführlich beschrieben. Gemische, die Verbindungen des Typs B) enthalten, sind in der DE-C 23 06 248 und der DE-C 27 18 254 offenbart. Verbindungen des Typs C) sind aus der EP-A 0 006 626 und 0 006 627 bekannt. Der Anteil der spaltbaren Verbindung beträgt allgemein 5 bis 70 Gew.-%, bevorzugt 5 bis 40 Gew.-%, bezogen auf das Gesamtgewicht der nichtflüchtigen Bestandteile der strahlungsempfindlichen Schicht.

Als strahlungsempfindliche Komponente, die beim Bestrahlen vorzugsweise starke Säure bildet bzw. abspaltet, ist eine große Anzahl von bekannten Verbindungen und Mischungen, wie Phosphonium-, Sutfonium- und Iodoniumsalzen, Halogenverbindungen und Organometall-Organohalogen-Kombinationen geeignet.

Die genannten Phosphonium-, Sulfonium- und Iodoniumverbindungen werden in der Regel in Form ihrer in organischen Lösemitteln löslichen Salze eingesetzt, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mindestens einem Halogenatom an einem Kohlenstoffatom oder an einem aromatischen Ring brauchbar. Von diesen Verbindungen sind die s-Triazinderivate mit Halogenmethylgruppen, insbesondere Trichlormethylgruppen, und einem aromatischen bzw. ungesättigten Substituenten im Triazin-Kern gemäß DE-C 27 18 259 (= US-A 4 189 323) bevorzugt. Ebenso geeignet sind 2-Trihalogenmethyl-[1,3,4]oxadiazole. Die Wirkung dieser halogenhaltigen Verbindungen kann auch durch bekannte Sensibilisatoren spektral beeinflußt und gesteigert werden.

Die Menge des Starters kann je nach seiner chemischen Natur und der Zusammensetzung der Schicht ebenfalls sehr verschieden sein. Günstige Ergebnisse erzielt man, wenn der Anteil des Starters etwa 0,1 bis 10 Gew.-%, bevorzugt 0,2 bis 5 Gew.-%, beträgt, jeweils bezogen auf das Gesamtgewicht der nichtflüchtigen Anteile der Schicht. Besonders für Kopierschichten von Dicken über 0,01 mm empfiehlt es sich, relativ wenig Säurespender zu verwenden.

Die lichtempfindliche Bildschicht kann auch auf einem positiv arbeitenden thermischen System basieren. Um eine Sensibilisierung gegenüber IR- bzw. Wärmestrahlung zu erhalten, eignen sich insbesondere Rußpartikel oder IR-absorbierende Farbstoffe. Unter IR-sensitiv soll hier- wie allgemein üblich- verstanden werden, daß das Gemisch bzw. die daraus gebildete Schicht für Strahlung mit einer Wellenlänge von 700 bis 1100 nm sensitiv ist. Rußpigmente eignen sich deshalb besonders als IR-absorbierende Komponente, da sie über einen breiten IR-Wellenlängenbereich absorbieren. Es können aber auch andere Verbindungen, die im IR-Bereich absorbieren, wie geeignet substituierte Phthalocyanine (z.B. PRO-JET 830 oder PRO-JET 950 NP von Zeneca Specialist Colours) oder Methinfarbstoffe, zur IR-Sensibilisierung benutzt werden. Für IR-Strahlung sensitive Gemische sind aus den DE-A 197 12 323, DE-A 197 39 302, EP-A 0 625 728 und 0 780 239 bekannt.

Die strahlungsempfindliche Schicht kann auch eine elektrophotographische Schicht sein. Dann enthält sie zweckmäßig einen organischen Photoleiter, einen Sensibilisator und ein organisches, polymeres Bindemittel.

Für negativ arbeitende Schichten geeignete oligomere oder polymere Verbindungen mit Diazoniumsalz-Gruppen sind dem Fachmann bekannt. Sie können auf übliche Weise durch Kondensation eines Diazomonomers (EP-A 0 152 819) mit einem Kondensationsmittel, wie Formaldehyd, Acetaldehyd, Propionaldehyd, Butyraldehyd, Isobutyraldehyd oder Benzaldehyd oder Aldehyden mit aciden Einheiten, wie *para-*Formyl-benzoesäure, hergestellt werden. Weiterhin lassen sich Mischkondensate verwenden, die außer den Diazoniumverbindungen noch andere, nicht lichtempfindliche Einheiten enthalten, die von kondensationsfähigen Verbindungen abgeleitet sind, insbesondere von aromatischen Aminen, Phenolen, Phenolethem, aromatischen Thioethern, aromatischen Kohlenwasserstoffen, aromatischen Heterocyclen oder organischen Säureamiden, die auch mit aciden Einheiten substituiert sein können. Besonders bevorzugte Diazoniumpolykondensationsprodukte sind Umsetzungsprodukte von Diphenylamin-4-diazoniumsalzen, die gegebenenfalls eine Methoxygruppe in dem die Diazogruppe tragenden Phenylrest enthalten, mit Formaldehyd oder 4,4'-Bis-methoxymethyl-diphenylether. Als Anion dieser Diazoharze eignen sich besonders aromatische Sulfonate, wie Toluol-4-sulfonat oder Mesitylensulfonat. Verbindungen mit Diazoniumsalzgruppen sind auch in der EP-A 030 862 offenbart. Insbesondere sind dort Verbindungen mit Gruppen der Formel

-X'-C(=Y)-X-R-Ar-N₂⁺ A⁻

beschrieben, wobei
- A⁻: ein Anion,
- Ar: einen aromatischen oder heteroaromatischen Rest,
- R: eine Einfachbindung oder einen gegebenenfalls substituierten aliphatischen und/oder aromatischen Rest,
- Y: ein Sauerstoff- oder Schwefelatom und
- X undX': unabhängig voneinander ein Sauerstoffatom, ein Schwefelatom oder eine gegebenenfalls substituierte Iminogruppe darstellen, wobei mindestens einer der Reste X und X' für eine gegebenenfalls substituierte Iminogruppe steht.

Der Anteil der oligomeren oder polymeren Verbindung(en) mit Diazoniumsalzgruppen beträgt vorzugsweise 3 bis 60 Gew.-%, bezogen auf das Gesamtgewicht der nichtflüchtigen Bestandteile des lichtempfindlichen Gemisches.

Die negativ arbeitende lichtempfindliche Komponente kann auch ein photopolymerisierbares System sein. Dieses setzt sich zusammen aus Photoinitiatoren, die im Bereich von 300 bis 1100 nm absorbieren, und (radikalisch) polymerisierbaren ethylenisch ungesättigten Bestandteilen. Als Photoinitiatoren eignen sich beispielsweise Grundkörper bzw. Derivate von Acetophenon, Benzophenon, Trichlormethyl[1,3,5]triazin, Benzoin, Benzoinethern, Benzoinketalen, Xanthon, Thioxanthon, Acridin, Porphyrin oder Hexaarylbisimidazol. Diese können in Verbindung mit einem unter Umständen substituierten Metallocen eingesetzt werden (EP-A 0 364 735). Der radikalisch polymerisierbare Bestandteil ist vorzugsweise ein Acryl- oder Methacrylsäurederivat mit einer oder mehreren ungesättigten Gruppen, vorzugsweise ein Ester der (Meth)acrylsäure. Er kann ein Monomer, Oligomer oder Präpolymer sein. Er kann in fester oder in flüssiger Form vorliegen, wobei feste und zähflüssige Formen bevorzugt sind. Zu den Verbindungen, die als Monomer geeignet sind, zählen beispielsweise Trimethylolpropantri(meth)acrylat, Pentaerythrithexa(meth)acrylat, Dipentaerythritpenta(meth)acrylat, Dipentaerithrithexa(meth)acrylat, Pentaerythrittetra(meth)acrylat, 1,1,1,3,3,3-Hexamethylol-propantetra(meth)acrylat (auch bezeichnet als "Ditrimethylolpropan-tetra(meth)acrylat"), Diethylenglykol-di(meth)acrylat, Triethylenglykol-di(meth)acrylat oder Tetraethylenglykol-di(meth)acrylat. Besonders bevorzugte radikalisch polymerisierbare, ethylenisch ungesättigte Verbindungen sind Acrylsäureester oder Alkylacrylsäureester mit mindestens einer bei Belichtung in Gegenwart des Initiators photooxydierbaren Gruppe, insbesondere einer Amino-, Harnstoff- Thio- oder Enolgruppe, sowie die Umsetzungsprodukte von Triethanolamin oder N,N'-(2-Hydroxy-ethyl)-piperidin mit Isocyanatoethyl-methacrylat oder von Triethanolamin und 2,2,4-Trimethyl-hexamethylendiisocyanat mit Glycidylacrylat. Als Monomer oder Comonomer einsetzbar sind schließlich auch Maleinimid, Dimethylmaleinimid und andere Derivates des Maleinimids. Geeignete Oligomere bzw. Präpolymere sind beispielsweise Polyurethane, Epoxidharze oder Polyester oder ungesättigte Polyesterharze, die polymerisierbare, ethylenisch ungesättigte Gruppen enthalten. Das sind speziell (Meth)acrylat-, Vinyl- oder Maleinat-Gruppen.

Der Anteil der Photoinitiatoren beträgt bevorzugt 0,5 bis 20 Gew.-%, der der radikalisch polymerisierbaren Verbindung 5 bis 80 Gew.-%, jeweils bezogen auf Gesamtgewicht der nichtflüchtigen Bestandteile des lichtempfindlichen Gemisches.

Eine Kombination der Diazoniumpolykondensationsprodukte mit einem radikalisch polymerisierbaren System bestehend aus Photoinitiatoren und ethylenisch ungesättigten Verbindungen, die radikalisch polymerisierbar sind, kann für bestimmte Anwendungen Vorteile bringen. Solche Hybridsysteme enthalten vorzugsweise 1 bis 50 Gew.-% Diazoniumpolykondensationsprodukte, 0,5 bis 20 Gew.-% Photoinitiatoren sowie 5 bis 80 Gew.-% der radikalisch polymerisierbare Verbindungen.

Zusätzlich können noch zahlreiche andere Oligomere und Polymere mitverwendet werden, z.B. Phenolharze vom Novolaktyp oder Vinylpolymere wie Polyvinylacetale, Poly(meth)acrylate, Polyvinylether und Polyvinylpyrrolidone, die gegebenenfalls selbst durch Comonomere modifiziert sind.

Zur Darstellung eines bildmäßigen Farbkontrastes unmittelbar nach der Belichtung enthalten die Schichten darüber hinaus noch eine Kombination von Indikatorfarbstoffen und strahlungsempfindlichen Komponenten, die beim Belichten starke Säuren bilden, wie oben beschrieben.

Die Menge des photochemischen Säurespenders kann, je nach seiner chemischen Natur und der Zusammensetzung der Schicht, ebenfalls sehr verschieden sein. Günstige Ergebnisse werden erhalten mit etwa 0,1 bis zu 10 Gew.-%, bezogen auf den Gesamtgewicht der nichtflüchtigen Bestandteile der Schicht.

Als Indikatorfarbstoffe haben sich kationische Farbstoffe wie Triphenylmethanfarbstoffe insbesondere in der Form ihrer Carbinolbasen und die Methinfarbstoffe besonders bewährt.

Ferner können dem strahlungsempfindlichen Gemisch noch lösliche oder auch feinteilige, dispergierbare Farbstoffe sowie UV-Absorber, Tenside, Polyglykolderivate und Pigmente zugesetzt werden.

Der Träger besteht bevorzugt aus einem dimensionsstabilen, platten- oder folienförmigen Material, insbesondere aus Metall, wobei Aluminium oder Aluminiumlegierungen besonders bevorzugt sind. Alumiumträger können in walzblanker Form eingesetzt werden oder sind mechanisch und/oder chemisch aufgerauht und gegebenenfalls auch anodisiert. Sie können auch noch chemisch vorbehandelt sein, beispielsweise mit Polymeren oder Polykondensaten, die Einheiten mit Phosphonsäure-, Carbonsäure- oder Sulfonsäuregruppen enthalten und gegebenenfalls auch noch Einheiten mit basischen Gruppen (insbesondere Aminogruppen) aufweisen können. Zur Vorbehandlung eignen sich femer Silikate, Phosphate, Fluoride oder Fluorokomplexe. Es können auch mehrere dieser Vorbehandlungen kombiniert sein. Als Träger sind schließlich auch Metall/ Kunststoff-Laminate geeignet, beispielsweise Aluminium/Polyester-Laminate.

Die Rückseitenbeschichtung besteht allgemein aus einem organischen polymeren Material mit einer Glas-Übergangstemperatur T_{g} von 45 °C oder mehr. Ihre Dicke beträgt allgemein 0,1 bis 20,0 µm, bevorzugt 0,5 bis 10 µm, besonders bevorzugt 1 bis 8 µm. Sie ist praktisch unlöslich in Wasser und wäßrig-alkalischen Entwicklern. Das polymere Material umfaßt beispielsweise Polyolefin (wie Polyethylen, Polypropylen, Polybutylen, Polybutadien oder Polyisopren), Polyester, Polycarbonat, Polyamid, Polysiloxan, Polystyrol, Homo- oder Copolymere aus bzw. mit Alkylacrylat- oder Alkylmethacrylat-Einheiten (wie Polymethylmethacrylat (PMMA) oder Styrol/Methylmethacrylat-Copolymere), Polyvinylacetal, Phenoxyharze (beispielsweise Harze aus Bisphenol-A und Epichlorhydrin), Polyvinylchlorid oder Polyvinylidenchlorid. Die Rückseitenbeschichtung kann darüber hinaus untergeordnete Mengen an Additiven, wie Weichmacher, Farbstoffe, Pigmente, Silikonverbindungen, oberflächenaktive Mittel oder andere Mittel zur Einstellung der gewünschten Oberflächeneigenschaften enthalten.

Neben den genannten polymeren Materialien kann die Rückseitenbeschichtung auch Verbindungen enthalten, die unter der Einwirkung von Hitze und/oder Strahlung polymerisieren, kondensieren oder vernetzen. Zu nennen sind beispielsweise additionspolymerisierbare Acrylate oder Methacrylate, wie Ethyl-(meth)-acrylat, Propyl(meth)acrylat, Butyl(meth)acrylat, (2-Hydroxy-ethyl)-methacrylat, Trimethylolpropan-mono-, -di- oder -tri(meth)acrylat oder Pentaerythrit-tri(meth)-acrylat; daneben auch (Meth)acrylamide, wie N-Methyl-, N-Ethyl-, N-Propyl-, N-Butyl- oder N-Isobutyl-(meth)acrylamid; Allylester, wie Allylacetat; Vinylether, wie Butyl-vinyl-ether, Octyl-vinyl-ether, Decyl-vinyl-ether, (2-Methoxy-ethyl)-vinyl-ether, Diethylenglykol-vinylether oder Benzyl-vinyl-ether; polyfunktionelle Urethanacrylate, die unter der Einwirkung von UV-Strahlung aushärten sowie Polyurethane, die bei Hitzeeinwirkung aushärten. "(Meth)acrylat" steht in der vorliegenden Anmeldung für acrylat und/oder methacrylat". Entsprechendes gilt für (meth)acrylamid und andere Derivate der Acrylsäure oder Methacrylsäure. Die Rückseitenbeschichtung kann demnach auch lichtempfindlich sein. Zur Unterscheidung davon wird die lichtempfindliche Schicht auf der Vorderseite des Trägers als "lichtempfindliche Bildschicht" bezeichnet, denn nur diese wird bildmäßig bestrahlt und entwickelt

Zur Herstellung der Rückseitenbeschichtung können die genannten Bestandteile in einem geeigneten, in der Regel organischen, Lösemittel gelöst oder dispergiert und auf den Träger aufgebracht werden. Das Lösemittel wird dann durch Erhitzen undloder im Vakuum abgezogen. Werden mechanisch, chemisch und/oder elektrochemisch behandelte Aluminiumträger eingesetzt, so kann die Beschichtung vor oder nach deren Behandlung aufgebracht werden. Die Beschichtung kann aufgeschleudert, aufgegossen oder mit mit Hilfe von Rakeln, Fließern oder anderen Vorrichtungen aufgebracht werden.

Das erfindungsgemäße Aufzeichnungsmaterial wird nach den üblichen, dem Fachmann bekannten Verfahren bildmäßig bestrahlt und entwickelt. In der Regel wird das Aufzeichnungsmaterial zunächst durch eine Negativ- oder Positiv-Vorlage hindurch in einem Vakuum-Kontaktkopierrahmen bildmäßig belichtet. Zur Belichtung werden häufig Kohle-Bogenlampen, Quecksilberdampflampen, Xenonlampen oder ähnliche Lichtquellen eingesetzt. Möglich ist auch eine direkte Bebilderung ohne Filmvorlage ("computer-to-plate"). Das bildmäßig belichtete bzw. bestrahlte Aufzeichnungsmaterial wird dann entwickelt, gewöhnlich mit einer wäßrig-alkalischen Lösung. Diese Lösung enthält allgemein ein Alkalisilikat sowie ein Alkali- oder Ammoniumhydroxid, gegebenenfalls auch Carbonate, Phosphate, Borate, Alkyl-, Dialkyl- oder Trialkylamine, Alkansäuren, untergeordnete Mengen an zumindest teilweise wassermischbaren organischen Lösemitteln und/oder Tenside.

Die folgenden Beispiele dienen zur Erläuterung der Erfindung. Die Abkürzung "Gt" steht darin für "Gewichtsteil(e)". Prozente sind Gewichtsprozente, soweit nicht anders angegeben. Vergleichsversuche und Vergleichsmaterialien sind durch ein Sternchen (*) gekennzeichnet.

Als Träger wurden
(I) eine in verdünnter Salzsäure aufgerauhte (mit einem Rz-Wert von 5,0 µm gemäß DIN 4768), in verdünnter, wäßriger Schwefelsäure zwischengebeizte und anodisierte (Gewicht der durch die Anodisierung erzeugten Aluminiumoxidschicht: 3,5 g/m²) und mit phosphonomethyliertem Polyethylenimin und mit Polyvinylphosphonsäure (entsprechend DE-A 44 23 140) hydrophilierte, 300 µm dicke Aluminiumfolie,
(II) eine in verdünnter Salzsäure aufgerauhte (Rz-Wert 5,0 µm gemäß DIN 4768), in verdünnter Schwefelsäure zwischengebeizte und anodisierte (Oxidgewicht 4,0 g/m²) und mit Polyvinylphosphonsäure hydrophilierte, 400 µm dicke Aluminiumfolie,
(III) eine in verdünnter Salpetersäure aufgerauhte (Rz-Wert 6,0 µm gemäß DIN 4768), in verdünnter Schwefelsäure zwischengebeizte und anodisierte (Oxidgewicht 2,0 g/m²), mit Polyvinylphosphonsäure hydrophilierte, 300 µm dicke Aluminiumfolie,
bereitgestellt und auf der Rückseite mit einer der Beschichtungen (a) bis (d) gemäß Tabelle 1, auf der Vorderseite mit einer der nachfolgend aufgeführten strahlungsempfindlichen Schichten (A) bis (H) oder (J) versehen. Die Schichten A, C, D, E und H sind positiv und die übrigen negativ arbeitend.

Die Rückseitenbeschichtungen wurden mit einem Rakel aufgetragen und in einem Umluftofen bei 120 °C 2 min lang getrocknet, während die Vorderseitenbeschichtungen durch Schleuderbeschichten hergestellt und im Umluftofen bei 125 °C 1 min lang getrocknet wurden.

**Tabelle 1**

| **Schicht** | **Schichtbestandteile** | **Schichtdicke nach dem Tocknen in µm** |
|---|---|---|
| a | 10 Gt eines Styrol/Methylmethacrylat-Copolymers mit einer T_{g} von 54 °C und 90 Gt Butan-2-on (= Methyl-ethyl-keton) | 3 µm |
| b | 10 Gt eines UV-härtbaren Lacks bestehend aus 90 Gt eines hexafunktionellen Urethan-acrylats (®Sartomer CN-975 von Sartomer), 5 Gt eines α-Hydroxy-ketons (®Esacure KIP 100F von Sartomer), 2 Gt Methyldiethanolamin von Elf Atochem und 3 Gt Benzophenon und 90 Gt Butan-2-on (Aushärtung erfolgte durch Bestrahlen mit einer UV-Lampe der Fa. IST (80 W) für 1 min; Entfernung der Lampe: 30 cm) | 10 µm |
| c | 10 Gt eines thermisch vernetzendes Polyurethans (®Desmotherm 2170 der Bayer AG) und 90 Gt Butan-2-on | 11 µm |
| d | 10 Gt eines Polymethylmethacrylats mit einer T_{g} von 49 °C und 90 Gt eines Gemisches aus Butan-2-on (90 %) und Xylol (10 %) | 5 µm |

| | | |
|---|---|---|
| **A** | 7,8 Gt | eines Cresol/Formaldehyd-Novolaks mit einer Hydroxylzahl von 420 (bestimmt gemäß DIN 53 783/DIN 53 240) und einem mittleren Molekulargewicht M_{w} von 6.000, bestimmt durch Gel-Permeations-Chromatographie (GPC) mit Polystyrol-Standard, |
| | 3,2 Gt | eines Veresterungsprodukts aus 1,5 mol 1,2-Naphthochinon-2-diazid-5-sulfonylchlorid und 1 mol 2,3,4-Trihydroxy-benzophenon, |
| | 0,4 Gt | 1,2-Naphthochinon-2-diazid-5-sulfonylchlorid, |
| | 0,2 Gt | Victoriareinblau (Color Index no. 44 045), |
| | 0,1 Gt | eines Kieselgelfüllstoffs mit einer mittleren Korngröße von 4 µm, |
| | ad 100 Gt | mit einem Gemisch aus 50 % Tetrahydrofuran (THF) und 50 % 1-Methoxy-propan-2-ol. |

Nach anschließendem Trocknen lag das Schichtgewicht bei 2 g/m².

| | | |
|---|---|---|
| **B** | 62 Gt | eines mit Maleinsäureanhydrid funktionalisierten Polyvinylbutyrals mit einem mittleren Molekulargewicht M_{w} von etwa 80.000, das 71 % Vinylbutyral-, 2 % Vinylacetat- und 27 % Vinylalkohol-Einheiten enthält, |
| | 21 Gt | eines Diazoniumpolykondensationsprodukts, hergestellt aus 1 mol 3-Methoxy-diphenylamin-4-diazoniumsulfat und 1 mol 4,4'-Bis-methoxymethyl-diphenylether in 85 %iger Phosphorsäure, isoliert als Mesitylensulfonat, |
| | 2,5 Gt | Phosphorsäure, |
| | 3,0 Gt | Victoriareinblau FGA (Basic Blue 81), |
| | 0,7 Gt | Phenylazodiphenylamin, |
| | 0,1 Gt | eines Kieselgelfüllstoffs mit einer mittleren Korngröße von 3 µm in |
| | 2570 Gt | Ethylenglykol-monomethylether und |
| | 780 Gt | Butan-2-on. |

Nach anschließendem Trocknen lag das Schichtgewicht bei 0,9 g/m².

| | | |
|---|---|---|
| **C** | 4,7 Gt | eines Cresol/Formaldehyd-Novolaks mit einer Hydroxylzahl von 420 (bestimmt gemäß DIN 53 783/DIN 53 240) und einem mittleren Molekulargewicht M_{w} von 6.000, bestimmt durch GPC mit Polystyrol-Standard, |
| | 1,9 Gt | eines Polyacetals aus Ethyl-butyraldehyd und Triethylenglykol, |
| | 0,23 Gt | 2-(4-Styryl-phenyl)-4,6-bis-trichlormethyl-s-triazin, |
| | 0,02 Gt | Kristallviolett, |
| | 0,1 Gt | eines Kieselgelfüllstoffs mit einer mittleren Korngröße von 4 µm, |
| | ad 100 Gt | mit einem Gemisch aus 90 % Butan-2-on und 10 % Ethylenglykol-monomethylether. |

Nach anschließendem Trocknen lag das Schichtgewicht bei 1,9 g/m².

| | |
|---|---|
| **D*** gemäß Beispiel 1 der EP-A 528 395 | |
| 4,5 Gt | eines Veresterungsprodukts aus 1,2-Naphthochinon-2-diazid-5-sulfonylchlorid und einem Pyrogallol/Aceton-Harz, |
| 11 Gt | eines Cresol/Formaldehyd-Novolaks, |
| 0,2 Gt | 2-(4-Methoxy-phenyl)-4,6-bis-trichlormethyl-s-triazin, |
| 0,1 Gt | Ölblau # 603 (erhältlich von Orient Chemical Industries Co., Ltd), |
| 0,04 Gt | eines Fluortensids (®Megafac F 177 von Dainippon Ink and Chemicals, Inc.) in |
| 100 Gt | Butan-2-on und |
| 100 Gt | Propylenglykol-monomethylether. |

Nach anschließendem Trocknen lag das Schichtgewicht bei 2,0 g/m².

Auf diese Schicht wurde eine Mattierungsschicht durch elektrostatisches Sprühbeschichten aufgetragen. Dazu wurde eine 12 %ige Lösung eines Methylmethacrylat/Ethylacrylat/Acrylsäure-Copolymers (Gewichtsverhältnis 65 : 20: 15), in dem ein Teil der Carboxygruppen neutralisiert war, hergestellt und bei 25 °C und 50 % relativer Feuchte mit einer Sprühglocke (25.000 Umdrehungen pro min) auf die lichtempfindliche Schicht aufgesprüht. Die Sprühglocke hatte gegenüber dem zu mattierenden Substrat eine Spannung von- 90 kV. Das sprühmattierte Substrat wurde 2,5 s später mit Wasserdampf besprüht und dann durch Aufblasen von 60 °C heißer Luft (10 % Feuchte) 5 s lang getrocknet. Dabei entstanden auf der lichtempfindlichen Schicht Mattierungspartikel mit einer durchschnittlichen Höhe von 6 µm und einer durchschnittlichen Ausdehnung von 30 µm. Die Mattierung hatte ein Gewicht von etwa 0,15 g/m².

| | | |
|---|---|---|
| E* | 7,8 Gt | eines Cresol/Formaldehyd-Novolaks mit einer Hydroxylzahl von 420 (bestimmt gemäß DIN 53 783/DIN 53 240) und einem mittleren Molekulargewicht M_{w} von 6.000, bestimmt durch GPC mit Polystyrol-Standard, |
| | 3,2 Gt | eines Veresterungsprodukts aus 1,5 mol 1,2-Naphthochinon-2-diazid-5-sulfonylchlorid und 1 mol 2,3,4-Trihydroxy-benzo-phenon, |
| | 0,4 Gt | 1,2-Naphthochinon-2-diazid-5-sulfonylchlorid, |
| | 0,2 Gt | Victoriareinblau (C.I. 44 045), |
| | ad 100 Gt | mit einem Gemisch aus 50 % THF und 50 % 1-Methoxypropan-2-ol. |

Nach anschließendem Trocknen lag das Schichtgewicht bei 1,9 g/m².

Auf die so hergestellte lichtempfindliche Schicht wurde dann mit elektrostatischer Unterstützung eine diskontinuierliche Mattierungsschicht aufgetragen. Dazu wurde eine Lösung aus 35 % eines Cresol/Formaldehyd-Novolaks und 65 % Ethylenglykol-ethylether-acetat (Leitfähigkeit der Lösung: 1,2 · 10⁷ pSi m ⁻¹) bei 30 °C mit Hilfe einer mit einer Kapillare versehenen elektrostatischen Vorrichtung aufgesprüht. Die Spitze der Kapillare befand sich in einem Abstand von 30 cm zur lichtempflndlichen Schicht; die Spannung der Kapillare gegenüber dem Substrat betrug- 30 kV. Die Sprührate lag bei 0,70 cm³/min. Die auf diese Weise erzeugten Mattierungspartikel hatten nach dem Trocknen einen Durchmesser zwischen 30 und 40 µm. Sie durchdrangen die strahlungsempfindliche Schicht nicht.

| | | |
|---|---|---|
| **F** | 4,5 Gt | eines Maleinsäureanhydrid/Methylmethacrylat-Copolymers mit einer Säurezahl von 100 bis 120 und einem mittleren Molekulargewicht M_{w} von 100.000, |
| | 2,0 Gt | eines Urethanacrylats (®Plex 6661 der Röhm AG), |
| | 3,0 Gt | eines Umsetzungsprodukts aus 1 mol Hexamethylendiamin und 2 mol (2-Hydroxy-ethyl)-methacrylat, |
| | 0,35 Gt | Phenylacridin, |
| | 0,10 Gt | Leukokristallviolett, |
| | 0,05 Gt | Kristallviolett, |
| | 0,1 Gt | eines Kieselgelfüllstoffs mit einer mittleren Korngröße von 4 µm, |
| | ad 100 Gt | mit einem Gemisch aus 70 % Glykolether (®Dowanol) und 30 % Butan-2-on. |

Nach anschließendem Trocknen lag das Schichtgewicht bei 1,0 g/m². Auf diese Schicht wurde eine weitere Schicht, hergestellt aus

| | |
|---|---|
| 7 Gt | eines Polyvinylalkohols mit 12 % Acetatgruppen, |
| 0,01 Gt | eines Fettalkohol-ethoxylats mit durchschnittlich 8 Ethylenoxid-Einheiten. |
| ad 100 Gt | mit Wasser |

aufgebracht und getrocknet Das Gewicht dieser Deckschicht betrug 2,0 g/m².

| | | |
|---|---|---|
| **G** | 4,5 Gt | eines Maleinsäureanhydrid/Methylmethacrylat-Copolymers mit einer Säurezahl von 100 bis 120 und einem mittleren Molekulargewicht M_{w} von 100.000, |
| | 2,0 Gt | eines Urethanacrylats (®Plex 6661 der Röhm AG), |
| | 3,0 Gt | eines Umsetzungsprodukts aus 1 mol Hexamethylendiamin und 2 mol (2-Hydroxy-ethyl)-methacrylat, |
| | 0,35 Gt | Phenylacridin, |
| | 0,10 Gt | Leukokristallviolett, |
| | 0,05 Gt | Kristallviolett, |
| | ad 100 Gt | mit einem Gemisch aus 70 % Glykolether (®Dowanol) und 30 % Butan-2-on. |

Nach anschließendem Trocknen lag das Schichtgewicht bei 0,9 g/m². Auf diese Schicht wurde ein Gemisch aus

| | |
|---|---|
| 7 Gt | eines Polyvinylalkohols mit 12 % Acetatgruppen, |
| 0,1 Gt | eines Kieselgelfüllstoffes einer mittleren Korngröße von 4 µm, |
| 0,01 Gt | eines Fettalkohol-ethoxylats mit durchschnittlich 8 Ethylenoxid-Einheiten, |
| ad 100 Gt | mit Wasser |

aufgebracht und getrocknet. Das Gewicht dieser Deckschicht betrug 1,8 g/m².

| | | | |
|---|---|---|---|
| **H** | 9,7 Gt | eines Cresol/Formaldehyd-Novolaks mit einer Hydroxylzahl von 420 (bestimmt gemäß DIN 53 783/DIN 53 240) und einem mittleren Molekulargewicht M_{w} von 6.000, bestimmt durch GPC mit Polystyrol-Standard, | |
| | 0,8 Gt | Poly(4-Hydroxystyrol) mit einem M_{w} von 4.000 bis 6.000 und einem M_{w} von 2.100 bis 3.100 (®Maruka Lyncur M, Typ S-2, von Maruzen Petrochemical Co., Ltd.), | |
| | 0,1 Gt | eines Kieselgelfüllstoffs mit einer mittleren Korngröße von 3 µm, | |
| | 8,0 Gt | einer Rußdispersion aus | |
| | | 5,00 Gt | Ruß (Spezialschwarz 250 der Degussa AG), |
| | | 66,00 Gt | des oben beschriebenen Novolak-Bindemittels (30 %ig in gamma-Butyrolacton), |
| | | 28,99 Gt | γ-Butyrolacton und |
| | | 0,01 Gt | Siliconentschäumer (RC 31 der Agfa-Gevaert AG). |
| | 40 Gt | Propylenglykol-monomethylether, | |
| | 31 Gt | Aceton und | |
| | 10,5 Gt | γ-Butyrolacton. | |

Nach anschließendem Trocknen lag das Schichtgewicht bei 2 g/m².

| | | |
|---|---|---|
| **J** | 62 Gt | eines mit Maleinsäureanhydrid funktionalisierten Polyvinylbutyrals mit einem mittleren Molekulargewicht M_{w} von etwa 80.000, das 71 % Vinylbutyral-, 2 % Vinylacetat- und 27 % Vinylalkohol-Einheiten enthält, |
| | 21 Gt | eines Diazoniumpolykondensationsprodukts, hergestellt aus 1 mol 3-Methoxy-diphenylamin-4-diazoniumsulfat und 1 mol 4,4'-Bis-methoxymethyl-diphenylether in 85 %iger Phosphorsäure, isoliert als Mesitylensulfonat, |
| | 2,5 Gt | Phosphorsäure, |
| | 3,0 Gt | Victoriareinblau FGA (Basic Blue 81), |
| | 0,7 Gt | Phenylazodiphenylamin und |
| | 0,1 Gt | eines Kieselgelfüllstoffs mit einer mittleren Korngröße von 0,5 µm in |
| | 2570 Gt | Ethylenglykol-monomethylether und |
| | 780 Gt | Butan-2-on. |

Nach anschließendem Trocknen lag das Schichtgewicht bei 0,35 g/m².

Geprüft wurde, wie sich die Aufzeichnungsmaterialien bei der Lagerung im Stapel und bei der Verarbeitung verhielten.

Die Resistenz der strahlungsempfindlichen Aufzeichnungsmaterialien gegenüber verschiedenen, beim Entwickeln bzw. beim Drucken häufig verwendeten Verarbeitungschemikalien wurde getestet. Dazu wurden sie
a) 4,5 min mit einem wäßrig-alkalischen Entwickler aus

| | |
|---|---|
| 0,12 mol | Na₂Si₃O₇, |
| 0,48 mol | Kaliumhydroxid, |
| 5,0 g | Natrium-pelargonat, |
| 1,0g | Nonylphenol-polyethylenglykolether mit durchschnittlich 10 Ethylenoxid-Einheiten, |
| 0,1 g | Silikonentschäumer (RC 31 der Agfa-Gevaert AG), |
| ad 1 I | mit vollentsalztem Wasser ("VE-Wasser"), |

b) 1 min mit reinem Isopropanol oder
c) 1 min mit einer 40%igen wäßrigen Diacetonalkohol-Lösung behandelt. Bei den erfindungsgemäßen Materialien betrug der Abtrag der Rückseitenbeschichtung bei a) jeweils weniger als 30 %, bei b) und c) jeweils zum Teil deutlich weniger als 10 %.

Die Lagerstabilität wurde wie folgt geprüft: Ein Stapel von 20 Platten wurde 48 Stunden lang bei 70°C mit einem 5-kg-Gewicht beschwert und die Schichtschädigungen wie folgt bewertet:
- + =: keinerlei Schäden
- o =: geringe Schäden
- - =: größere Verklebungen

Die Resultate sind in der folgenden Tabelle zusammengestellt.

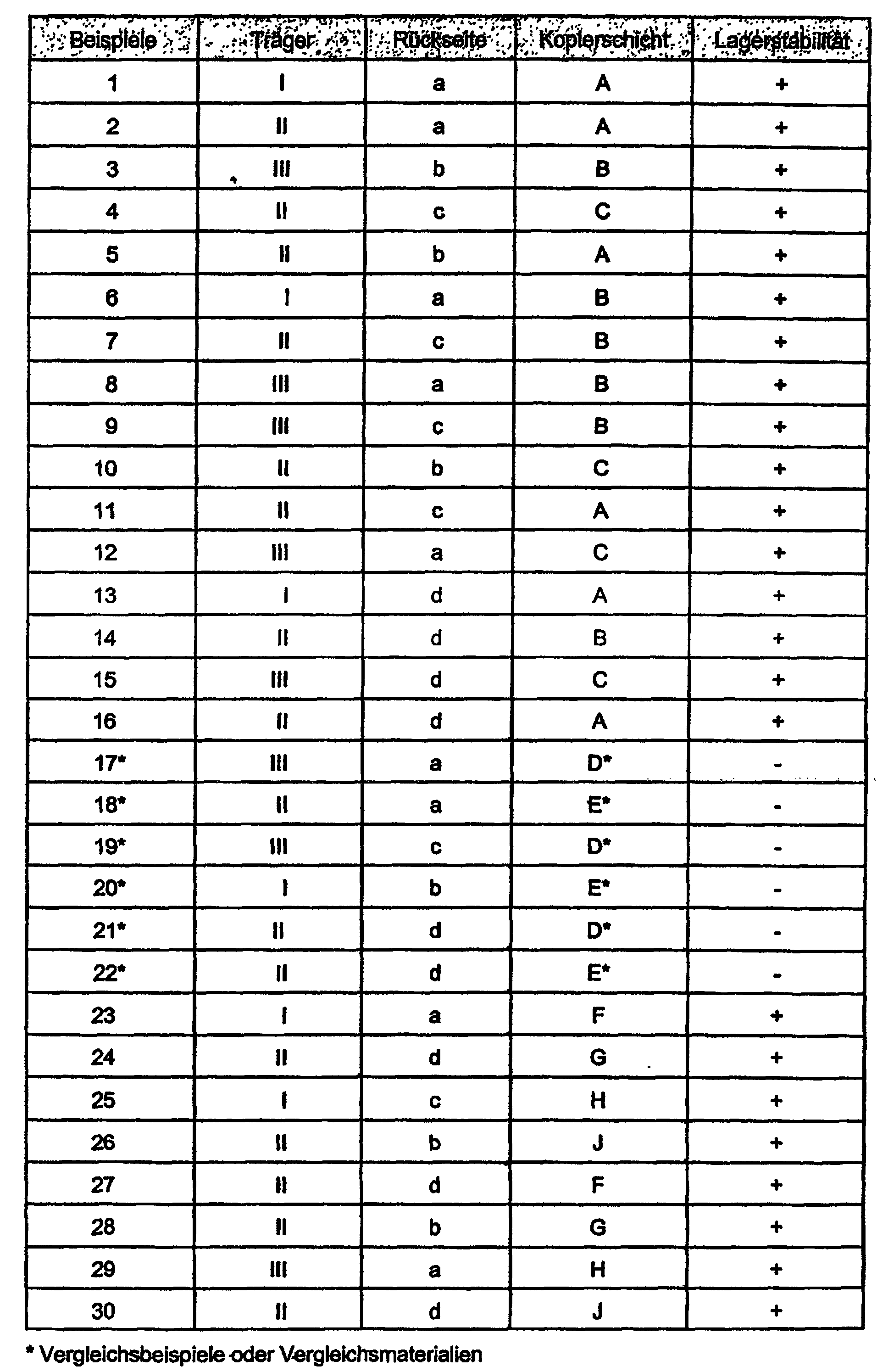

## Patentansprüche

1. Aufzeichnungsmaterial zur Herstellung einer Offsetdruckplatte mit einem Träger, auf dessen Vorderseite sich eine lichtempfindliche Bildschicht und auf dessen Rückseite sich eine Schicht aus einem organischen polymeren Material mit einer Glas-Übergangstemperatur T_{g} von 45 °C oder mehr befindet, **dadurch gekennzeichnet, daß** die lichtempfindliche Bildschicht oder eine gegebenenfalls darüber befindliche Deckschicht ein Pigmentierungsmittel, das aus einem anorganischen Material besteht und praktisch unlöslich in Wasser ist, enthält.

2. Aufzeichnungsmaterial gemäß Anspruch 1, **dadurch gekennzeichnet, daß** die mittlere Korngröße der Pigmentierungspartikel 0,1 bis 15,0 µm, bevorzugt 0,5 bis 10,0 µm, besonders bevorzugt 3 bis 5 µm, beträgt.

3. Aufzeichnungsmaterial gemäß Anspruch 1 oder 2, **dadurch gekennzeichnet, daß** das Pigmentierungsmittel ein Kieselsäureprodukt ist.

4. Aufzeichnungsmaterial gemäß Anspruch 3, **dadurch gekennzeichnet, daß** das Kieselsäureprodukt mit einem Tensid kombiniert ist, bevorzugt mit einem Tensid mit Siloxan-Einheiten.

5. Aufzeichnungsmaterial gemäß Anspruch 4, **dadurch gekennzeichnet, daß** der Anteil des Tensids 0,01 bis 2 Gew.-%, bezogen auf das Trockengewicht der Schicht, beträgt.

6. Aufzeichnungsmaterial gemäß einem oder mehreren der Ansprüche 1 bis 5, **dadurch gekennzeichnet, daß** der Anteil des Pigmentierungsmittels 0,01 bis 10 Gew.-%, bevorzugt 0,1 bis 5 Gew.-%, jeweils bezogen auf das Trockengewicht der Schicht, beträgt.

7. Aufzeichnungsmaterial gemäß einem oder mehreren der Ansprüche 1 bis 6, **dadurch gekennzeichnet, daß** die lichtempfindliche Bildschicht eine positiv arbeitende Schicht ist, die auf Naphthochinondiaziden, Kombinationen von Verbindungen, die bei Bestrahlung eine starke Säure bilden, und Verbindungen, die mindestens eine durch eine Säure spaltbare C-O-C-Bindung enthalten, oder auf thermischen Systemen basiert.

8. Aufzeichnungsmaterial gemäß einem oder mehreren der Ansprüche 1 bis 6, **dadurch gekennzeichnet, daß** die lichtempfindliche Bildschicht eine elektrophotographische Schicht ist.

9. Aufzeichnungsmaterial gemäß einem oder mehreren der Ansprüche 1 bis 7, **dadurch gekennzeichnet, daß** die lichtempfindliche Bildschicht eine negativ arbeitende Schicht ist, die auf Verbindungen mit Diazoniumsalz-Gruppen und/oder auf Photopolymersystemen basiert.

10. Aufzeichnungsmaterial gemäß einem oder mehreren der Ansprüche 1 bis 9, **dadurch gekennzeichnet, daß** die strahlungsempfindliche Bildschicht ein Schichtgewicht von 0,1 bis 6 g/m², bevorzugt von 0,5 bis 4,0 g/m², aufweist.

11. Aufzeichnungsmaterial gemäß einem oder mehreren der Ansprüche 1 bis 10, **dadurch gekennzeichnet, daß** die Rückseitenbeschichtung eine Dicke von 0,1 bis 20,0 µm, bevorzugt 0,5 bis 10 µm, besonders bevorzugt 1 bis 8 µm, aufweist.

12. Aufzeichnungsmaterial gemäß einem oder mehreren der Ansprüche 1 bis 11, **dadurch gekennzeichnet, daß** die Rückseitenbeschichtung des Trägers Verbindungen enthält, die unter der Einwirkung von Hitze und/oder Strahlung polymerisiert, kondensiert oder vernetzt worden sind.

13. Aufzeichnungsmaterial gemäß einem oder mehreren der Ansprüche 1 bis 12, **dadurch gekennzeichnet, daß** die Rückseitenbeschichtung Additive, wie Weichmacher, Farbstoffe, Pigmente, Silikonverbindungen, oberflächenaktive Mittel oder andere Mittel zur Einstellung der gewünschten Oberflächeneigenschaften enthält.

## Claims

1. A recording material for the production of an offset printing plate, having a substrate on the front of which a photosensitive image layer is present and on the back of which a layer of an organic polymeric material having a glass transition temperature T_{g} of 45°C or more is present, wherein the photosensitive image layer or any top layer present thereon contains a pigmenting composition comprising an inorganic material and being virtually insoluble in water.

2. The recording material as claimed in claim 1, wherein the mean particle size of the pigmenting particles is from 0.1 to 15.0 µm, preferably from 0.5 to 10.0 µm, particularly preferably from 3 to 5 µm.

3. The recording material as claimed in claim 1 or 2, wherein the pigmenting composition is a silicic acid product.

4. The recording material as claimed in claim 3, wherein the silicic acid product is combined with a surfactant, preferably with a surfactant having siloxane units.

5. The recording material as claimed in claim 4, wherein the amount of the surfactant is from 0.01 to 2% by weight, based on the dry weight of the layer.

6. The recording material as claimed in one or more of claims 1 to 5, wherein the amount of the pigmenting composition is from 0.01 to 10% by weight, preferably from 0.1 to 5% by weight, based in each case on the dry weight of the layer.

7. The recording material as claimed in one or more of claims 1 to 6, wherein the photosensitive image layer is a positive-working layer which is based on naphthoquinonediazides, combinations of compounds which form a strong acid on exposure to radiation, and compounds which contain at least one C-O-C bond cleavable by an acid, or is based on thermal systems.

8. The recording material as claimed in one or more of claims 1 to 6, wherein the photosensitive image layer is an electrophotographic layer.

9. The recording material as claimed in one or more of claims 1 to 7, wherein the photosensitive image layer is a negative-working layer which is based on compounds having diazonium salt groups and/or on photopolymer systems.

10. The recording material as claimed in one or more of claims 1 to 9, wherein the radiation-sensitive image layer has a layer weight of from 0.1 to 6 g/m², preferably from 0.5 to 4.0 g/m².

11. The recording material as claimed in one or more of claims 1 to 10, wherein the backing coating has a thickness of from 0.1 to 20.0 µm, preferably from 0.5 to 10 µm, particularly preferably from 1 to 8 µm.

12. The recording material as claimed in one or more of claims 1 to 11, wherein the backing coating of the substrate contains compounds which have been polymerized, condensed or crosslinked under the action of heat and/or radiation.

13. The recording material as claimed in one or more of claims 1 to 12, wherein the backing coating contains additives, such as plasticizers, dyes, pigments, silicone compounds, surfactants or other compositions for establishing the desired surface properties.

## Revendications

1. Matériau d'enregistrement pour la fabrication d'un cliché d'impression offset comprenant un support sur le côté frontal duquel se trouve une couche photosensible portant une image et sur le côté dorsal duquel se trouve une couche constituée d'une matière polymère organique qui possède une température de transition vitreuse Tg de 45 °C ou plus, **caractérisé en ce que** la couche photosensible portant une image ou une couche de recouvrement se trouvant, le cas échéant, par-dessus ladite couche contient un agent de pigmentation qui est constitué par une matière inorganique et qui est pratiquement insoluble dans l'eau.

2. Matériau d'enregistrement selon la revendication 1, **caractérisé en ce que** la granulométrie moyenne des particules de pigmentation s'élève de 0,1 à 15,0 µm, de préférence de 0,5 à 10,0 µm, de manière particulièrement préférée de 3 à 5 µm.

3. Matériau d'enregistrement selon la revendication 1 ou 2, **caractérisé en ce que** l'agent de pigmentation est un produit à base d'acide silicique.

4. Matériau d'enregistrement selon la revendication 3, **caractérisé en ce que** le produit à base d'acide silicique est combiné avec un agent tensioactif, de préférence avec un agent tensioactif comprenant des unités de siloxane.

5. Matériau d'enregistrement selon la revendication 4, **caractérisé en ce que** la fraction de l'agent tensioactif s'élève de 0,01 à 2 % en poids, rapportés au poids à sec de la couche.

6. Matériau d'enregistrement selon l'une ou plusieurs des revendications 1 à 5, **caractérisé en ce que** la fraction de l'agent de pigmentation s'élève de 0,01 à 10 % en poids, de préférence de 0,1 à 5 % en poids, chaque fois rapportés au poids à sec de la couche.

7. Matériau d'enregistrement selon une ou plusieurs des revendications 1 à 6, **caractérisé en ce que** la couche photosensible portant une image est une couche à traitement positif qui se base sur des naphtoquinonediazides, sur des combinaisons de composés qui forment, lors d'une exposition à un rayonnement, un acide fort et de composés qui contiennent au moins une liaison -C-O-C- apte à être clivée par un acide, ou encore sur des systèmes thermiques.

8. Matériau d'enregistrement selon une ou plusieurs des revendications 1 à 6, **caractérisé en ce que** la couche photosensible portant une image est une couche électrophotographique.

9. Matériau d'enregistrement selon une ou plusieurs des revendications 1 à 7, **caractérisé en ce que** la couche photosensible portant une image est une couche à traitement négatif qui se base sur des composés contenant des groupes de sel de diazonium et/ou sur des systèmes de photopolymères.

10. Matériau d'enregistrement selon une ou plusieurs des revendications 1 à 9, **caractérisé en ce que** la couche portant une image sensible au rayonnement présente un poids de la couche de 0,1 à 6 g/m², de préférence de 0,5 à 4,0 g/m².

11. Matériau d'enregistrement selon une ou plusieurs des revendications 1 à 10, **caractérisé en ce que** la couche dorsale présente une épaisseur de 0,1 à 20,0 µm, de préférence de 0,5 à 10 µm, de manière particulièrement préférée de 1 à 8 µm.

12. Matériau d'enregistrement selon une ou plusieurs des revendications 1 à 11, **caractérisé en ce que** la couche dorsale du support contient des composés qui sont soumis à une polymérisation, à une condensation ou à une réticulation sous l'influence de la chaleur et/ou d'une exposition à un rayonnement.

13. Matériau d'enregistrement selon une ou plusieurs des revendications 1 à 12, **caractérisé en ce que** la couche dorsale contient des additifs tels que des plastifiants, des colorants, des pigments, des composés de silicone, des agents tensioactifs ou d'autres agents pour régler les propriétés superficielles désirées.
